# EUROPEAN PATENT APPLICATION

(11) **EP 0 844 617 A2**
(43) Date of publication of application: **27.05.1998**
(21) Application number: 97120551.3
(22) Date of filing: 24.11.1997
(51) Int. Cl.: G11C 8/00, G11C 11/36, G11C 11/38

(54) **Improvements in or relating to electronic circuits**

(30) Priority: 25.11.1996 US 31737 P
(71) Applicant: Texas Instruments Incorporated, Dallas, Texas 75265 (US)
(72) Inventor: Blake, Terence G.W., Dallas, TX 75230 (US); van der Wagt, Jan P., Dallas, TX 75206 (US)
(74) Representative: Schwepfinger, Karl-Heinz, Dipl.-Ing.

(57) **Abstract**

A two-port memory cell includes a bistable latch of two series connected resonant tunnel diodes (RTDs) 34, 38 connected between supply (+Pwr) and substrate (-Pwr) voltages, the common node 36 of the two RTDs being coupled to both the reading and writing functions of the cell. The writing function is achieved by a field effect pass transistor 30 whose active electrodes 25, 28 are tied between the common node of the RTDs and the bit writing bus WB and whose gate 26 is tied to the digital memory word writing bus WW. The reading function is achieved with a sense amplifier n-channel transistor 46 with the source tied to the negative power supply, the gate 40 tied to the common node 36 of the RTDs and the drain 42 tied to an electrode 48 of an n-channel pass transistor 53 which connects the sense amplifier drain 42 to the read bit line RB depending on the gate voltage of the pass transistor 53 whose gate 50 is tied to the read word line RW.

## Description

### TECHNICAL FIELD OF THE INVENTION

The present invention relates generally to electronic circuits and, more specifically, to very high speed digital memory using differentially negative resistance devices such as resonant tunneling diodes and the like.

### BACKGROUND OF THE INVENTION

The primary integrated semiconductor memory device is the dynamic random access memory (DRAM). The capacity of a single DRAM integrated circuit (IC) is approaching a gigabit. The most common circuit configuration for a single bit uses a single metal-oxide-semiconductor (MOS) pass transistor in conjunction with a capacitor. This IT/IC DRAM cell has the smallest possible size ranging between 4F² and 8F² where F is the minimum feature size. The digital storage of a DRAM degrades with time as its capacitor charge leaks away. This leakage requires that a DRAM be periodically refreshed approximately once each millisecond.

Static RAM (SRAM) requires no refresh and is generally faster than DRAM, 25 nsec access for SRAM versus 80 nsec for DRAM. However, SRAM uses more active elements and consumes more power than DRAM. Typically the size of an SRAM cell is 60F² because it requires either eight transistors or four transistors with two polysilicon load resistors. It would be highly desirable to have memory cells the size of DRAM with the performance of SRAM. Previously, in related applications (U.S. Patent Application Serial Nos. 08/858,073, 08/858,074 and 08/883,737) assigned to the assignee of the present invention, the use of resonant tunnel diodes (RTD) as small geometry, ultrahigh speed, bistable devices suitable for SRAM has been taught.

Extensive prior art exists in the application of two terminal negative resistance devices developed after the publication by Leo Esaki of "New Phenomenon in Narrow Germanium p-n Junctions", *Phys. Rev.,* Vol. 109, p.603, January 15, 1958. However, as the title of Esaki's article indicates a resonant tunnel diode (RTD) with its plurality of thin semiconducting layers having different physical properties is markedly different from Esaki's single p-n junction. Although the shape of the plot of device current vs. voltage is superficially similar, the scale is different. In addition, the manufacturing technology available to achieve massive arrays of virtually identical RTDs is not available for Esaki tunnel diodes. In its simplest form, an RTD consists of a sequence of five semiconductor layers. The outer two layers are the contact layers into which electrons enter and exit the semiconductor layer sequence. The interior three dissimilar semiconductor layers differ in their energy band gaps in the sequence of wide/narrow/wide band gap with layer thicknesses comparable to the electron Bloch wavelength (typically less than 10 nm). The electron path through these layers consists of two energy barriers separated by a narrow region referred to as a quantum well.

Classically, an electron with energy, called Fermi energy, approaching the first energy barrier with an energy below the barrier energy is reflected. As the physical dimensions of the barrier decrease toward the wavelength of the particle, there is an increasing probability that the particle will be transmitted instead of reflected. Thus, under certain conditions, an electron can pass through the barrier with energy below the barrier potential. This phenomenon is called tunneling.

If the quantum well width is selected to be approximately equal to some half integer multiple of the electron wavelength, a standing wave can be built up by constructive interference analogous to the standing waves in a transmission line or microwave cavity. Electrons at these wavelengths couple into and out of the quantum well more readily than others.

Since the electron's energy can be controlled by adjusting the voltage across the structure, the current flow through the double barrier is quite sensitive to this applied voltage. For certain applied voltages, the electrons readily pass through the double barrier and for other applied voltages are almost totally reflected. The electron is said to be in resonance when the incoming electron energy matches the resonant transmission energy of the quantum-well structure.

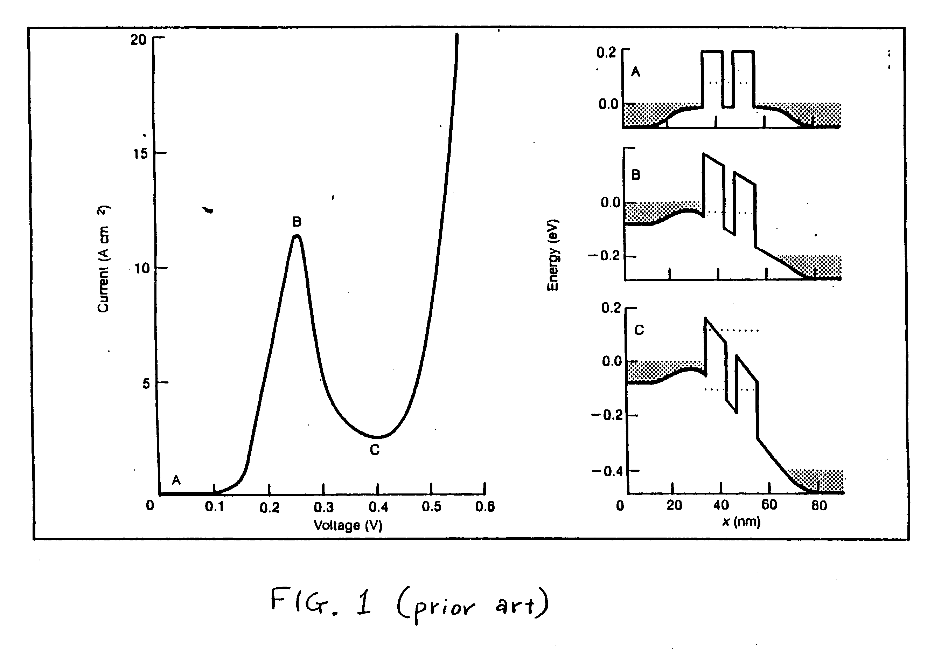

The prior art shown in Figure 1, "Resonant Tunneling Transistors", *TI Technical Journal*, p. 30, Jul-Aug 1989, shows the current vs. voltage (IV) characteristic and the corresponding conduction band profile of an RTD. The interesting feature of this characteristic is that between points B and C where an increase in applied voltage actually causes a decrease in device current. This region of "negative differential resistance" is highly unstable. The ratio of the voltage at B to C is referred to as the peak-to-valley ratio and is quite important in determining the noise margins of RTDs applied to digital devices. The previously mentioned scale differences in these characteristics between RTDs and older Esaki single junction tunnel diodes is quite dramatic. RTDs can be fabricated whose peak currents are reproducible from device to device and may range from 100 picoamps to greater than 100 milliamps while maintaining useable peak to valley ratios. Esaki diodes operate in the tens of milliamps regime. This allows RTDs to be tailored to the application. In memory devices where power and size are the prime concerns, very low current devices are the choice. In high speed logic where relatively large capacitive loads may occur, high current devices are desired.

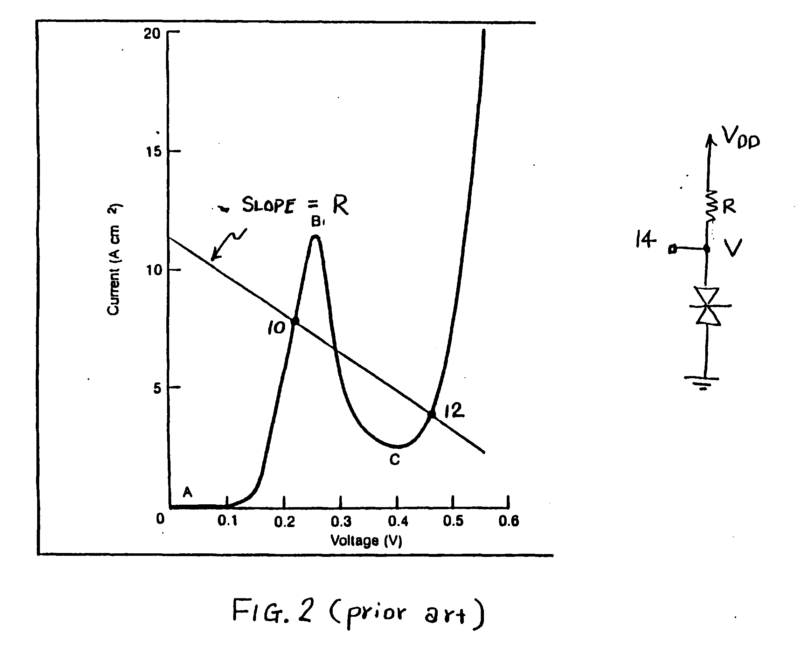

As has been done in prior art, adding a resistor in series with the diode as illustrated in Figure 2 achieves a bistable circuit whose static resting point is either 10 or 12. By applying a control voltage at 14, the device can be forced to either 10 or 12 making it into a resettable binary latch. This structure is disadvantageous because of;
(1) power dissipation;
(2) manufacturability; and
(3) operating speed among other problems.

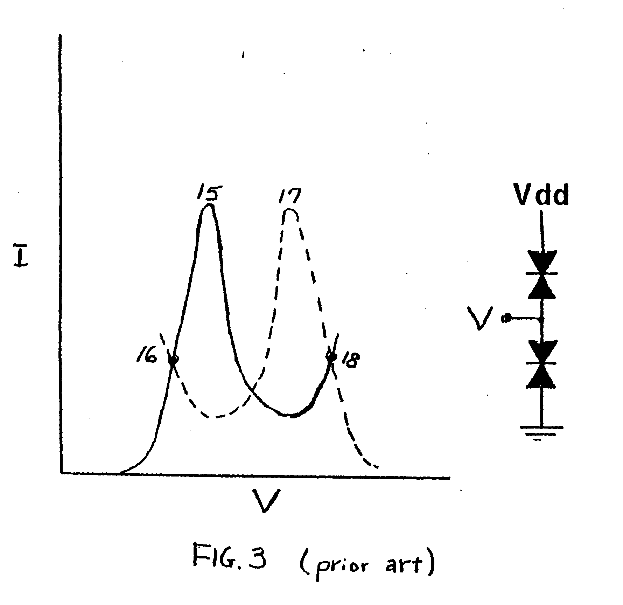

A more suitable structure is to series connect two RTDs in a manner similar to that proposed by Goto, et al in *IRE Trans. On Electronic Computers*, March 1960, p. 24 using conventional Esaki tunnel diodes and studied extensively by RCA, *RCA Review*, vol XXXIII, Jun 1963, p. 152 and Dec 1962 p.489. The series connection of two RTDs and their bistable operating points 16 and 18 is illustrated in Figure 3.

### SUMMARY OF THE INVENTION

In view of the above mentioned difficulties of state-of-the-art digital memory technology, it is a primary objective of the present invention to provide memory cells with the functionality of a two-port SRAM, but with cell density closer to that of DRAM. A two-port memory cell has separate buses for writing and reading a bit to and from the cell. A two-port SRAM is particularly desirable for a very high speed, pipelined computer architecture.

The present invention includes a memory cell comprising a bistable latch of two series connected resonant tunnel diodes connected between the supply and substrate voltages, the common node of the two RTDs being coupled to both the reading and writing functions of the cell. The writing function is achieved by a field effect pass transistor whose active electrodes are tied between the common node of the RTDs and the bit writing bus and whose gate is tied to the digital memory word writing bus. The reading function is achieved with a sense amplifier n-channel transistor with the source tied to the negative power supply, the gate tied to the common node of the RTDs and the drain tied to an electrode of an n-channel pass transistor which connects the sense amplifier drain to the read bit line depending on the gate voltage of the pass transistor whose gate is tied to the read word line.

The pass transistor connected to the write bit line can be p-channel or n-channel. If p-channel, a relatively poor FET with normally undesirable leakage (such as might be realized with a thin film transistor) could be used. For greater cell density, this pass transistor can be n-channel. In either case the digital zero or one state is forced by turning on this pass transistor with the write word line excitation which forces the common node of the RTDs to the voltage state of the write bit line.

To read the state of the cell, the read word line drives the base of the sense n-channel pass transistor positive which couples the source of the sense amplifier to the read bit line. Depending on the digital state of the common node of the RTDs, the current flowing from the read bit line will reflect the digital state of the common node.

Both the word read and write lines may be excited simultaneously. Separate bit read and write lines could be selected to write to a selected cell while simultaneously reading from another selected cell.

### BRIEF DESCRIPTION OF THE DRAWING

The foregoing features of the present invention may be understood more fully from the following detailed description, read in conjunction with the accompanying figures in which like numerals and symbols are employed to designate similar components in various views unless otherwise indicated:
Figure 1 illustrates a graph of the current through an RTD versus voltage and the corresponding energy level diagrams;
Figure 2 illustrates the bistable operating points of an RTD with a load resistor;
Figure 3 illustrates the resulting bistable operating points of two RTDs connected in series;
Figure 4 illustrates a two port memory cell which achieves simultaneous reading and writing to different memory cells through the use of a p-channel pass transistor whose electrical leakage characteristics may be high (normally undesirable) or low depending on the chosen manufacturing technology. This pass transistor is normally used as a gate to select the cell for a write operation to force the desired digital zero or one state; and
Figure 5 illustrates a two port memory cell which achieves simultaneous reading and writing to different memory cells through the use of an n-channel pass transistor which offers the most compact geometry for the function. This pass transistor is normally used as a gate to select the cell for a write operation to force the desired digital zero or one state.

### DESCRIPTION OF THE PREFERRED EMBODIMENTS

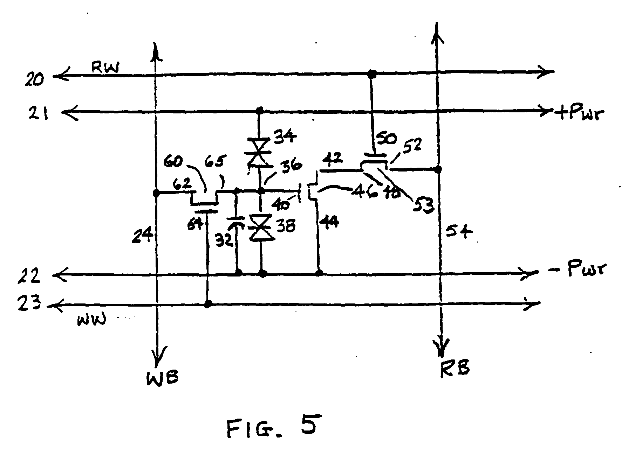

Referring to Figure 5 RTDs 34 and 38 perform the bistable latch function described in reference to Figure 3. Illustrated are six buses which are common to certain other memory cells in the dual port random access memory: (1) the positive power supply bus 21 and negative power supply bus 22 common to all cells; (2) the word read bus 20 and word write bus 23 common to all cells of a particular word (row) and (3) the bit read bus 54 and bit write bus 24 common to all cells in a particular column.

The basic functionality will be described using a high potential on node 36 as a digital one and low potential as a digital zero. With both the write bit line 24 and write word line 23 held low, the active electrodes 25 and 26 of the p-channel pass transistor 30 are close to the same potential since the gate of 30 is at low potential. The current carrying capacity of 30 is great enough to force node 36 to a low potential digital zero. If capacitor 32 stored a positive voltage digital one, that is rapidly discharged. When the writing conditions terminate, the low voltage condition of node 36 is maintained by RTDs 34 and 38. Any leakage from surrounding circuitry that attempts to charge the capacitor 32 positive toward an error state of one will be over ridden by the current sinking capability of RTD 38.

Writing a high potential digital one to the cell is quite analogous to that just described except the word bit line 24 is at the digital one or high potential. Should surrounding circuitry leakage attempt to leak away the digital one state of node 36, the current carrying capacity of RTD 34 offsets such leakage to maintain the digital one.

The digital state of the cell is basically "remembered" by the charge on capacitor 32 like a DRAM cell. Although capacitor 32 is shown specifically for the purpose of explanation, it should be understood that such capacitance is formed by the circuit parasitic capacitance which can be deliberately controlled by choice of circuit geometries. However, the state of 32 and thus node 36 is maintained by a continual "refresh" from RTDs 34 and 38 which achieves a function like an SRAM, one of the objects of this invention. Since the RTDs need only to offset very low leakage currents, the size of the RTDs can be ultra-small to achieve small cell geometry - another object of this invention.

To read the digital state of the cell, the read word bus 20 and read bit bus 54 are selected. A positive voltage on 20 turns n-channel FET 53 "ON" by driving gate 50 high. The active electrodes 48 and 52 of 53 are near the same potential which couples the drain 42 of sense transistor 46 to the read bit bus. Sense transistor 46 is n-channel and has its gate tied to node 36 and its source 44 tied to the negative supply bus. If node 36 is in the one state, sense transistor 46 will sink current from the bit read bus 54 via 53. This condition will be sensed by a common bit sense amplifier (not shown) tied to 54. If node 36 is in the low voltage digital zero state at the time the cell is read, very little current will be drained from the read bit bus 54, thus signaling that a digital zero has been stored by the selected cell.

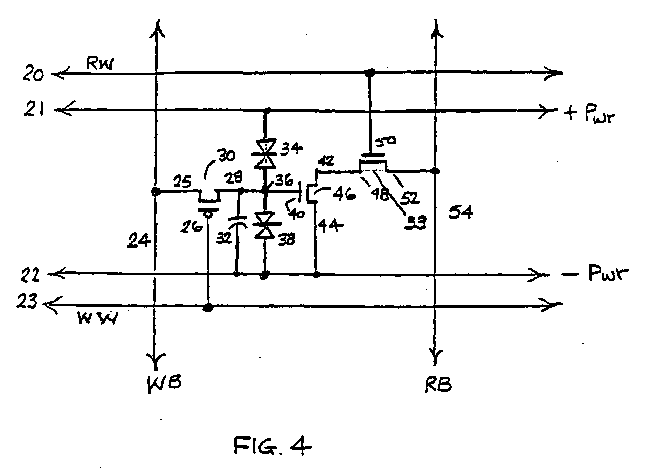

With the previous description of Figure 4 cell operation, it can be seen that a memory made up of a plurality such cells has the capability of writing to one cell while reading from another - a previously stated desired result. During the simultaneous read and write operations, the same bit lines (column) could be used but not the same word lines (row).

It should be pointed out that since the RTDs 34, 38 are offsetting circuit leakage, the pass transistor 30 could contribute leakage as well without deleterious effects. This means that 30 could be a thin film device such as might be used in staked geometry for even more compactness.

If the pass transistor 30 of Figure 4 were made n-channel, the manufacturing technology allows a two-port memory cell which is quite compact. This is shown in Figure 5. As can be seen there is no change in circuit configuration, only in the polarity of the gate 64 voltage which controls pass transistor 60 to place a high or low impedance between node 36 and bit write line 24. All other functional description is the same as for the cell shown in Figure 4.

While the principles of the present invention are disclosed herein, it will be recognized that various departures may be undertaken in the practice of this invention. For example, in some applications it may be more desirable to have a "true" static memory with the node capacitance of the common RTD nodes held as low as possible. Nothing has been said concerning the specific architecture of the two port memory, that is whether it is n x 1, n x 8, n x 64 or whatever topology. In addition the "n-channel", "p-channel" FET terminology is not meant to be restrictive as it may change as available manufacturing materials change. Although the terms "row" and "column" have been used for descriptive purposes, interchanging these terms causes no change in functionality. The scope of the invention is not intended to be limited to the particular structures and connections disclosed herein.

## Claims

1. A two-port memory cell having separate buses for writing and reading data to and from said cell, said memory cell comprising:
a bistable latch comprising two series connected resonant tunnel diodes (RTDs) connected between a supply potantial and a substrate potential, a common node of the two RTDs being coupled to said bus for reading and writing data to and from said cell.

2. The memory cell in accordance with Claim 1 further comprising;
a write pass transistor having a control electrode coupled to a word writing bus, and having a conductance path coupled between the common node of said RTDs and a bit writing bus.

3. The memory cell in accordance with Claim 2 wherein said write pass transistor is a field effect transistor.

4. The memory cell in accordance with Claim 2 or Claim 3 wherein said write pass transistor is an n-channel field effect transistor.

5. The memory cell in accordance with Claim 2 or Claim 3, wherein said write pass transistor is a p-channel field effect transistor.

6. The memory cell in accordance with any preceding claim further comprising;
a sense amplifier field effect transistor and a read pass transistor, the source electrode of said sense amplifier transistor being coupled to the substrate voltage, the gate electrode of said sense amplifier transistor being coupled to said common node of said RTDs and the drain electrode of said sense amplifier transistor being coupled to a conductance path electrode of said read pass transistor, the other conductance path electrode of said read pass transistor being coupled to a read bit bus, the gate electrode of said read pass transistor being coupled to a word bus.

7. The memory cell in accordance with Claim 6 wherein said read pass transistor is an n-channel device.

8. The memory cell in accordance with Claim 6 or Claim 7 wherein said read pass transistor is an n-channel field effect transistor.
